# EUROPEAN PATENT SPECIFICATION

(11) **EP 2 833 084 B1**
(45) Date of publication and mention of the grant of the patent: **12.10.2016**
(21) Application number: 13179085.9
(22) Date of filing: 02.08.2013
(51) Int. Cl.: F25B 15/10, H05K 7/20, C09K 5/04

(54) **Refrigeration apparatus and method**
Kühlvorrichtung und Verfahren
Appareil de refroidissement et procédé

(43) Date of publication of application: 04.02.2015
(73) Proprietor: ABB Research Ltd., 8050 Zürich (CH)
(72) Inventor: Agostini, Bruno, CH-5405 Baden Daetwill (CH); Habert, Mathieu, CH-5405 Baden Daetwill (CH); Agostini, Francesco, CH-5405 Baden Daetwill (CH); Paul, Thomas, CH-5405 Baden Daetwill (CH)
(74) Representative: Kolster Oy Ab

(56) References cited:
- US-A- 3 065 609
- US-A- 3 977 853
- US-A1- 2009 178 436
- US-B1- 7 394 655
- ZOHAR A ET AL: "Performance of diffusion absorption refrigeration cycle with organic working fluids", INTERNATIONAL JOURNAL OF REFRIGERATION, ELSEVIER, PARIS, FR, vol. 32, no. 6, 1 September 2009 (2009-09-01), pages 1241-1246, XP026421668, ISSN: 0140-7007 [retrieved on 2009-01-27]
- "SELF-SUFFICIENT COOLING SYSTEM FOR ELECTRONIC COMPONENTS", IBM TECHNICAL DISCLOSURE BULLETIN,, vol. 30, no. 6, 1 November 1987 (1987-11-01), pages 389-390, XP001450208,

## Description

### BACKGROUND OF THE INVENTION

### FIELD OF THE INVENTION

This invention relates to a solution for cooling electric components of an electric apparatus.

### DESCRIPTION OF PRIOR ART

Conventional refrigeration systems are dual pressure cycles where the saturation temperature difference between a condenser and an evaporator is produced by a system pressure difference. This requires a mechanical input to drive the compressor or pump for generating the change in pressure. A drawback with such a prior art system is the need for an mechanical input to drive a compressor or pump.

In order to avoid the use of a compressor or pump, diffusion-absorption cycle referred to as the Von Platen - Munters has been developed where a generator, an evaporator and condenser with suitable fluids are utilized for driving the cycle. Different variants of such a cycle are disclosed in US - 3 065 609 A, Zohar et al., "Performance of diffusion absorption refrigeration cycle with organic working fluid", Internal journal of refrigeration, Elsevier, Paris, vol. 32, no 6, September 1, 2009, and in US - 7 394 655 B1, for instance. In a diffusion-absorption cycle of this type, the number of components is, however, unnecessarily high which increases the costs. Additionally, the relative positions of the components is such that integration of a cycle of this type into an apparatus cooling electric components has an unfavorable impact on the outer dimensions of the apparatus.

Previously there also exists solutions referred to as the Einstein-Szilard diffusion absorption cycle utilizing a generator, an evaporator and an absorber-condenser manufactured of steel and circulating three different working fluids without the need for an mechanical input, compressor or pump. In a cycle of this type the number of components needed and the relative positions of the components is more favorable. A problem with this known solution is, however, low efficiency and high manufacturing costs.

### SUMMARY OF THE INVENTION

An object of the present invention is to solve the above mentioned drawback and to provide a novel apparatus which provides more efficient cooling of electric components and a method for selecting working fluids for a cooling system. This and other objects are achieved with the apparatus of independent claim 1 and the method of independent claim 11.

### BRIEF DESCRIPTION OF DRAWINGS

In the following the present invention will be described in closer detail by way of example and with reference to the attached drawings, in which
Figures 1 to 7 illustrate a first embodiment of an apparatus, and
Figure 8 illustrates the operation of an apparatus.

### DESCRIPTION OF AT LEAST ONE EMBODIMENT

In the following the absorber fluid is designated by the letter A, the refrigerant by the letter R and the inert fluid (or pressure equalizing fluid) by the letter I. The liquid state is designated by the letter 1 and the gas state by the letter g (it is to be understood that "gas" is used to distinguish from liquid state and comprises vapor state, i.e. a liquid that has just undergone phase change). Thus, for example A-1 designates liquid absorber and (R+I)-g a mixture of refrigerant and inert fluids in the gas state. Practically all the flows in the apparatus are mixtures of two fluids with low or high concentrations, but to simplify the description, only high concentration mixtures are explicitly mentioned as such. Thus it is to be understood that A-1 is liquid absorbant which may have a low concentration of inert absorbed, while (A+I)-1 is a liquid absorbant which may have a high concentration of inert absorbed.

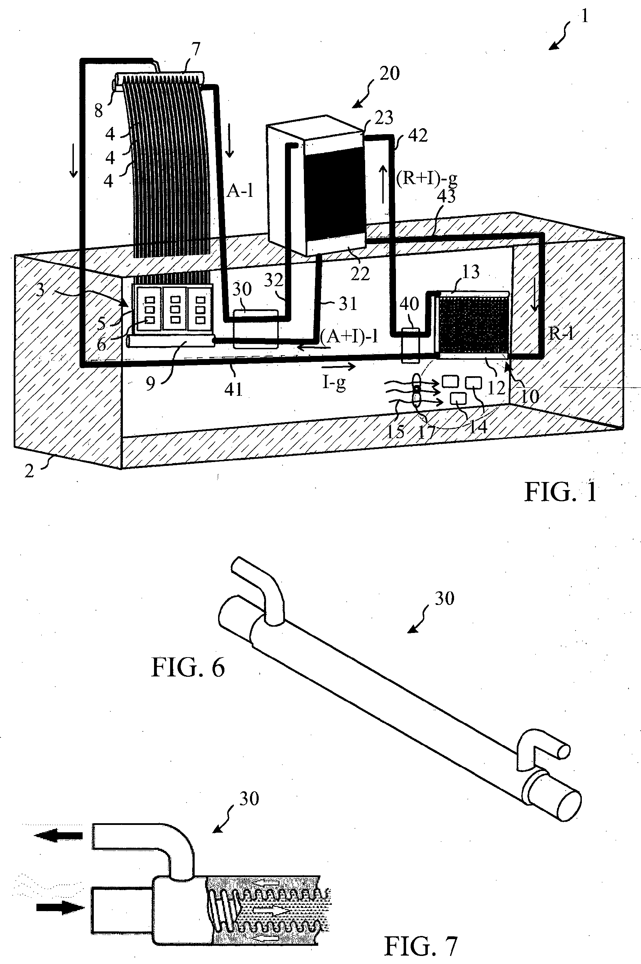

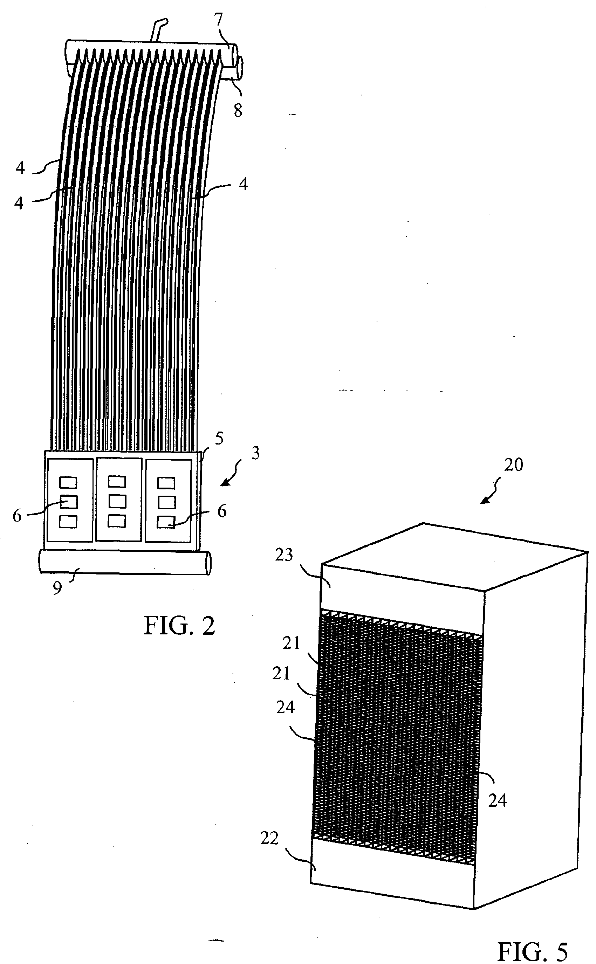

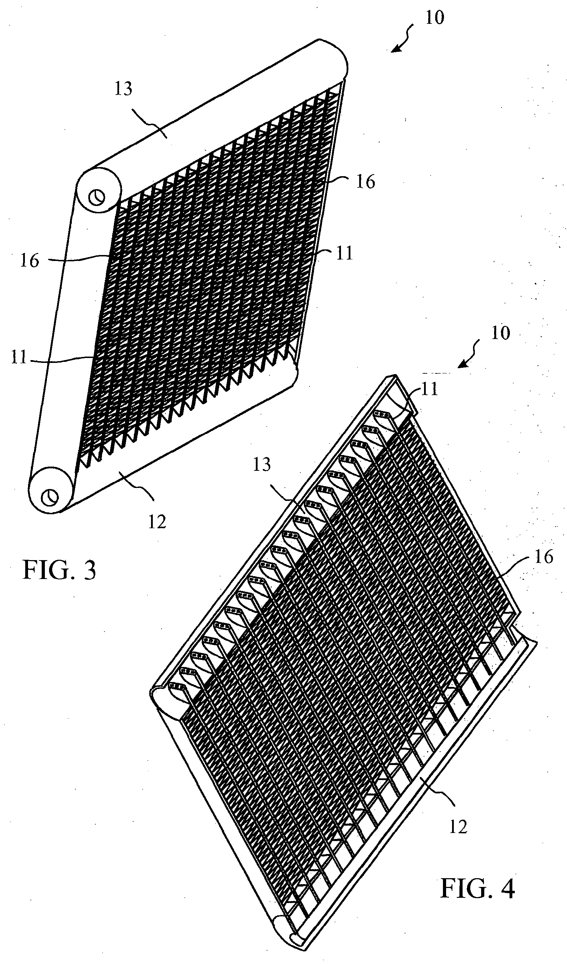

Figures 1 to 7 illustrate a first embodiment of an apparatus 1. Figure 1 is a front view of the apparatus, Figure 2 illustrates details of the generator, Figures 3 and 4 details of the evaporator, Figure 5 details of the absorber- condenser and Figures 6 and 7 of the solution heat exchanger.

The apparatus 1 comprises a tight enclosure 2 enclosing electric devices, such as an electrical cabinet or a component space. Tight refers in this context to an enclosure 2 which restricts air from flowing between the inside and outside of the enclosure, though in practical implementations some leakage may occur. The electric components within this hermetic enclosure 2 are cooled as explained below. It should, however, be observed that a tight enclosure is not necessary in all embodiments. One alternative instead of having a tight enclosure is, for instance, to have two separate airflows that do not mix together. The first air flow may pass heat towards the evaporator, for instance, while the other separate airflow passes heat away from the condenser-absorber, for instance.

A cooling element referred to as a generator 3 is arranged with a lower part within the enclosure 2 and with an upper part outside of the enclosure. The generator 3 includes a plurality of tubes 4 which are divided by longitudinal internal walls into a plurality of channels. One alternative is to manufacture the tubes of the generator of multiport extruded tubes (MPE tubes). Such tubes may be manufactured by extruding aluminum, for instance.

The generator 3, which is illustrated in more detail in Figure 2, is at its lower end provided with a baseplate 5. Such a baseplate 5 may be manufactured of aluminum, for instance. Electric components 6 which during use produce large amounts of heat are attached to the baseplate 5 and thermally connected to the baseplate 5 for conducting heat from the electric components 6 via the baseplate 5 to fluid in the tubes 4. The electric components 6 may be high power electronic components of a motor drive used for supplying an electric motor with electricity, for instance.

The baseplate 5 is provided with parallel grooves into which the tubes 4 partly penetrate. Some of the longitudinal channels of the MPE tubes are therefore embedded into the baseplate 5.

At the upper end of the generator 3, the tubes 4 are connected to a first manifold 7. This manifold may be implemented as a tube providing a fluid path between each of the channels in the tubes 4. A reservoir 8 is provided as a second tube, which is in fluid communication with the manifold 7 and located lower than the manifold 7. Thereby liquid and gas exiting the channels of the tubes 4 at the upper ends of the tubes are separated by gravity. The liquid flows downwards by gravity and accumulates into the reservoir 8 while the gas remains in manifold 7.

From Figures 1 and 2 one can observe that the tubes 4 are curved. The reason for this curvature is to ensure that the liquid will accumulate into the liquid reservoir 8 by gravity. Therefore this generator 3 manufactured of curved multiport extruded tubes in Figures 1 and 2 fulfills three different functions:

- A vapour generator: gas is generated inside the section of the tubes 4 that penetrate into the baseplate 5 due to the heat dissipated by the electric components 6, such as power modules.

- A bubble pump: The internal longitudinal channels of the tubes 4 are capillary sized channels. In this context "capillary sized" refers to channels that have a size small enough for bubbles to grow uniquely in a longitudinal direction (in other words in the longitudinal direction of the channel as opposed to the radial direction) and thereby create a so called bubble lift effect by pushing the liquid upwards. The diameter of a channel or tube which is considered capillary depends on the fluid or refrigerant that is used (boiling) inside. The following formula, for instance, can be used to evaluate a suitable diameter: D = (sigma/(g*(rhol-rhov)))^0.5, wherein sigma is the surface tension, g the acceleration of gravity, rhov the gas density and rhol the liquid density. Typically the internal diameter of such capillary channels is around 1.5 mm. Therefore bubbles will grow along the channels direction towards the lowest pressure point only and therefore push liquid up to the top of the tubes 4 into the manifold 7.

- A separator reservoir: the manifold 7 and the reservoir 8 have one or more fluid connections and therefore act as a vapour-liquid separator and reservoir due to gravity and the mutual location of the manifold and reservoir.

The apparatus 1 of Figure 1 also includes an evaporator 10, which is illustrated in more detail in Figures 3 and 4. The evaporator 10 is composed of an air heat exchanger with tubes 11 attached to a bottom manifold 12 (implemented as a tube) and a top manifold 13 (implemented as a tube).

In the illustrated example the tubes 11 are MPE tubes with longitudinal intermediate walls that divide the tubes into a plurality of channels. Air fins 16 are brazed between the parallel tubes 11.

An inert gas I-g is injected into a liquid refrigerant R-1 with a diffuser tube inserted into the bottom manifold 12, for instance. The evaporated mixture of refrigerant and inert is collected into the top manifold 13. The evaporator 10 can be made of MPE tubes, but this is not necessary.

The evaporator 10 provides cooling to secondary electric components 14 arranged inside the tight enclosure 2. These secondary electric components 14 are thermally connected to the evaporator 10. One alternative is that the thermal connection is obtained by an air stream 15 passing via the electric components 14 to the fins 16 of the evaporator 10, such that the fins 16 conduct heat from the air stream 15 to fluid in the tubes 11. In order to provide an efficient air circulation within the enclosure 2, a fan 17 generating the air stream 15 may be utilized. The electric components 14 may be capacitors and PCBs (Printed Circuit Board) which during use typically generate a relatively low amount of heat, but which require an efficient cooling in order to avoid problems due to a temperature raise. Typically the power of the second components 14 may be 5 to 10 times lower than the power of the electric components 6 components.

The apparatus 1 of Figure 1 comprises an absorber-condenser 20, shown in more detail in Figure 5. The absorber-condenser 20 is installed outside of the tight enclosure 2. The illustrated absorber-condenser 20 is composed of an air heat exchanger with tubes 21 attached to a bottom manifold 22, which may be implemented as a tube, and a top manifold 23, which also may be implemented as a tube. In order to enhance transfer of heat between the absorber-condenser 20 and the surrounding air, fins 24 are arranged between the tubes 21 by brazing, for instance. Additionally, a second fan (not illustrated) may be arranged outside of the enclosure 2 to generate an airflow passing between the tubes 21 of the absorber-condenser 20.

The absorber-condenser 20 may be manufactured of aluminum, for instance, by a plate and bar heat exchanger technology, for instance. The absorber-condenser 20 preferably respects the following constraints:

a) the flow length of the channels provided by the tubes 21, and therefore the height of the absorber-condenser, should be high enough to allow complete absorption of the inert gas I-g into the absorber in a liquid state A-1 and of the refrigerant received in a gas state R-g in to a liquid state R-1. This height can be determined with classical heat and mass transfer correlations.

b) the cold weak absorber in a liquid state A-1 coming from the solution heat exchanger 30 is allowed to shower evenly the refrigerant+inert gas mixture (R+1)-g entering the top manifold 23. Therefore the top manifold 23 may be designed for this purpose, with a porous plate inserted in the middle for example.

c) during the absorption and condensation processes, which take place together, the different fluids have a contact area as large, as possible. Therefore the diameter of the fluid channels provided by the tubes 21 is large enough to avoid the formation of gas slugs and liquid plugs (typically a few times the capillary dimension) because these would keep the gas and liquid spatially separated and hinder the absorption process.

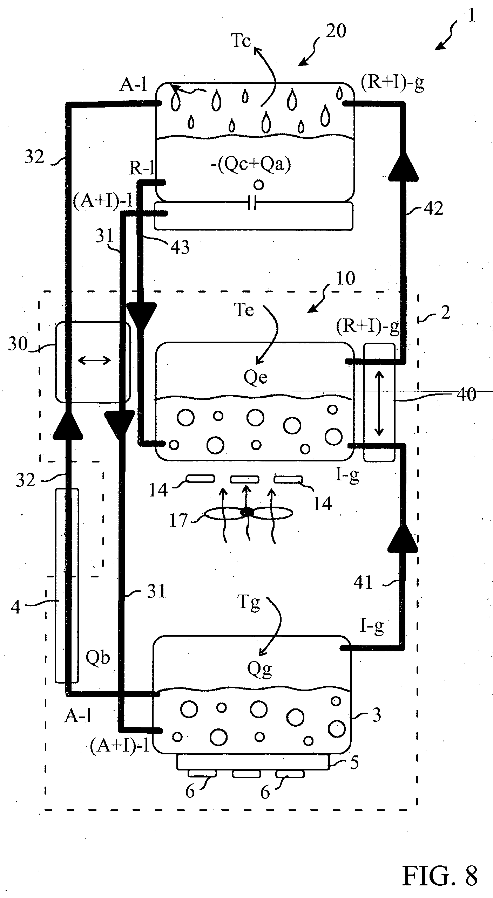

d) the liquid pure refrigerant R-1 and the liquid strong solution of absorbant+inert (A+I)-1 are harvested in the bottom manifold 22. As these two fluids are immiscible and of different densities, they will separate naturally by gravity (illustrated in Figure 8). The size and design of the bottom manifold 22 allows this natural separation to occur. Alternatively a commercial liquid-liquid separator (not illustrated in the Figures) may be installed below the bottom manifold 22.

The apparatus of Figure 1 also comprises a solution heat exchanger 30 that can be a standard commercial tube-in-tube heat exchanger as shown in more details in Figures 6 and 7, and where the liquid strong absorber line 31 (containing the mixture of absorber and inert in a liquid state (A+I)-1) pre-cools the liquid weak absorber line 32 (containing the absorber in a liquid state A-1). It should be observed that in Figure 1 the solution heat exchanger 30 representation is simplified and shown as two tubes 31 and 32 running side by side. Although this configuration would allow heat exchange, the tube-in-tube commercial solution is much more efficient because it has a larger heat transfer area.

The apparatus of Figure 1 also includes a gas heat exchanger 40 that can be a standard commercial tube-in-tube heat exchanger, similar as the solution heat exchanger 30 illustrated in Figures 6 and 7.

It should be observed that in Figure 1 heat transfer occurs only between the line 41 with inert in the gas state I-g and the line 42 with a mixture of refrigerant and inert (R+I)-g, both in a gas state. However, as an alternative it is possible to have line 42 with a mixture of refrigerant and inert (R+I)-g to pre-cool both line 41 with inert in gas state I-g and line 43 with the refrigerant in a liquid state R-1 before they enter the evaporator 10. This can be achieved by installing two tube-in-tube heat exchangers 40 in series, for instance.

A line 41 with inert in gas state I-g extends from the top manifold 7 of the generator 3 to the bottom manifold 12 of the evaporator 10 through the gas heat exchanger 40. A line 32 with the liquid weak absorber A-1 extends from the liquid reservoir 8 of the generator 3 to the top manifold 23 of the absorber-condenser 20 through the solution heat exchanger 30. A line 31 with a liquid strong absorber (A+I)-1 extends from the bottom manifold of the absorber-condenser 22 to the bottom manifold 9 of the generator 3 through the solution heat exchanger 30.

The line 43 with the liquid refrigerant R-1 extends from the bottom manifold 22 of the absorber-condenser 20 to the bottom manifold 12 of the evaporator 10 and optionally through the gas heat exchanger 40. Line 43 should exit from the manifold 22 of the absorber-condenser 20 above the level of liquid strong solution of absorbant+inert (A+I)-1 exiting via line 31(as shown in Figure 8). In this way adequate separation is obtained due to gravity.

A line 42 with a gas refrigerant+inert mixture in a gas state (R+I)-g extends from the top manifold 13 of the evaporator 10 to the top manifold 23 of the absorber-condenser 23 through the gas heat exchanger 40.

As most clearly illustrated in Figure 1, the tubes 4, which may be MPE tubes of aluminum, for instance, extend out of the enclosure to a higher altitude than the top of the absorber-condense 20. This ensures efficient circulation within the apparatus.

Figure 8 illustrates the operation of the apparatus. The apparatus illustrated in Figures 1 to 7 may operate as explained in the following.

Three different fluids are circulated in the apparatus 1, an absorber A, a refrigerant R and an inert I (which also is called a pressure equalizing gas). The absorber A and inert I should have a large boiling temperature difference to allow a good separation of the absorber A and inert I fluid in the generator. The saturation temperature of the refrigerant R at the system pressure must be greater than the saturation temperature of the inert I at the system pressure. The inert I should be strongly absorbed by the absorber A at the system pressure and at the saturation temperature of the refrigerant R. The refrigerant R should be nearly immiscible with the absorber A and inert I fluid mixture. The three fluids may not chemically react with each other or with other materials present in the apparatus, which may be manufactured of aluminum, for instance. The absorber A fluid should have a high saturation temperature at the system pressure. Ideally the refrigerant R and inert I mixture should be able to form an azeotrope in the evaporator temperature so that there is no temperature glide during the evaporation, which would improve the coefficient of performance.

The apparatus illustrated in Figure 8 has six heat exchangers circulating three fluids, as explained above. The terms "weak" and "strong" are used to refer to the amount of inert gas in the mixture.

A pre-heated strong liquid solution of inert and absorber (A+I)-1 enters the generator 3 from the solution heat exchanger 30 via line 31. This liquid solution is vaporized by the heat load Qg from the electric components 6 and produces a strong gas mixture of inert I-g and absorber and a weak liquid solution of inert and absorber A-1.

The upper end of the generator 3, which may be provided with tubes 4 (having capillary dimensions) partly extending out of the enclosure 2 (as illustrated in Figure 1) works as a bubble pump starting from the generator tank (bottom manifold 9 of the generator 3). The bubble pump 4 sends the absorber in a liquid state A-1 to the solution heat exchanger 30 via line 32, due to the growth of spatially confined bubbles created in the bubble pump due to the capillary size of the pipes 4 and the heat load Qb. The solution heat exchanger 30 pre-cools the weak liquid solution of the absorber A-1 sent by the bubble pump with the strong liquid solution of inert and absorber (A+I)-1 coming out of the absorber-condenser 20 via line 31. This pre-cooling increases the capacity of the absorber liquid A-1 to absorb more inert I-g in the absorber-condenser 20 and therefore improves the effectiveness of the cycle. Optionally the weak solution A-1 can be further pre-cooled with the outside air before it enters the absorber-condenser 20.

The inert gas line 41 passes the strong gas mixture of the inert gas I-g to the gas heat exchanger 40 from the generator 3. The gas heat exchanger 40 precools the inert gas I-g (which at this point ideally consists to 100% of inert gas, but in praxis may contain some absorber gas) with the strong inert and refrigerant gas mixture (R+I)-g coming out from the evaporator 10. Due to this pre-cooling refrigeration may occur in the evaporator.

The absorber-condenser 20, which is located outside of the enclosure 2, has a double function: firstly it receives the pre-heated strong inert and refrigerant gas mixture (R+I)-g coming out from the gas heat exchanger 40 via line 42 and showers it with the pre-cooled weak absorber liquid A-1 coming out from the solution heat exchanger 30 in order to absorb the inert gas I-g into the absorber A-1, thus forming a strong liquid solution of inert (A+I)-1 at the exit of the absorber-condenser 20 (line 31). Secondly it condenses the refrigerant into liquid R-1 above atmospheric air temperature, which is possible since the partial pressure of the refrigerant without the inert is high. Then the two non-miscible liquids R-1 and (A+I)-1 are separated at the bottom manifold 22 of the absorber-condenser 20 by gravity. Both the absorption and condensation are exothermic phenomena and reject a total heat load (Qc+Qa) into the surroundings outside of the enclosure 2. Qa is the absorption heat and Qc is the condensation heat.

The evaporator 10 receives liquid refrigerant R-1 from the absorber-condenser 20 via line 43. The liquid refrigerant may optionally (not illustrated in the drawings) be precooled in a gas heat exchanger. Additionally, the evaporator 10 receives via line 41 pre-cooled strong gas mixture of inert I-g from the generator 3 via the gas heat exchanger 40. The inert in the gas state I-g reduces a partial pressure of the liquid refrigerant R-1 and therefore also the temperature required for evaporating the liquid refrigerant R-1. The relatively low heat load Qe from the electric components 14 attached to the evaporator 10 or arranged inside the enclosure where they are thermally connected to the evaporator via air (and possibly a fan 17 generating an airflow), is therefore sufficient in the presence of inert gas I-g to evaporate the liquid refrigerant R-1. Evaporation can therefore be achieved a relatively low temperature Te. This phenomena is endothermic and absorbs a heat load Qe from inside of the tight enclosure 2.

Attention should be paid to the selection of the fluids utilized in the apparatus. In order to be able to utilize heat exchangers manufactured of materials that efficiently conduct heat, suitable fluids needs to be selected. Preferably, it is possible to utilize aluminum in the heat exchangers, as aluminum has good heat conducting properties (as compared to steel for instance) and as heat exchangers of aluminum are relatively easy to manufacture by extrusion and/or a combination of extrusion and soldering, for instance. Furthermore they are compact and low cost.

Generally speaking the process for selecting fluid combinations to be used in the previously described apparatus may be as follows:

1) Choose a refrigerant + inert combination and a working pressure so that:

i) at 100% refrigerant the condensation temperature will be significantly higher than the cooling air temperature (at least 10 K higher).

ii) a certain concentration of refrigerant mixed with inert gas exists so that this mixture will evaporate at a significantly lower temperature than that of the enclosure to be cooled (at least 10 K lower). This concentration should be ideally around 50% to minimize flow rates. However it can vary from 10% to 90% typically.

iii) the difference between the condensation and the evaporation temperature is called the temperature lift and indicates how much below ambient you can hope to refrigerate the enclosure containing the electronic equipment.

2) Choose an absorber fluid so that at the working pressure determined by the refrigerant + inert combination and at the absorption temperature (that is equal to the condensation temperature since the two phenomena take place in the same heat exchanger), the concentration of inert gas in the absorber is as high as possible. This will ensure that the generator exit temperature is as low as possible (and therefore the semiconductor operating temperature is low) and that the concentration of absorber in the vaporized inert gas is as low as possible (which improves the coefficient of performance since this absorber gas does not play any refrigeration role in the evaporator).

For the described apparatus utilizing aluminum in the heat exchangers excellent fluid combinations may be achieved with the following fluid combinations:
- as the inert fluid R134a (1,1,1,2-Tetrafluoroethane) in combination with butane as the refrigerant fluid, or
- as the inert fluid R32 (Difluoromethane) in combination with cyclopropane as the refrigerant fluid.

With the above two alternatives, possible absorbers are:
- alkyl acetamides, linear and cyclic, such as DMEU (Dimethylol-ethyleneurea) or DMAC (Dimethylacetamide)
- carbonate esters, such as DMC (Dimethyl carbonate)
- glycol ethers, such as DMEDEG (Dimethylether diethylene glycol), DMETEG (DiMethyl Ether Tetra Ethylene Glycol), DMETrEG (Dimethylether Triethylene Glycol).

The use of the novel combination of inert, refrigerant and absorber as working fluids in the apparatus makes it possible to manufacture the components of the apparatus of a material which is very well suitable for use in a cooling device, in other words aluminum. This also simplifies the manufacturing of the apparatus.

It is to be understood that the above description and the accompanying figures are only intended to illustrate the present invention. It will be obvious to a person skilled in the art that the invention can be varied and modified without departing from the scope of the invention.

## Claims

1. An apparatus (1) comprising a generator (3), an evaporator (10) and an absorber-condenser (20) circulating an absorber, an inert and a refrigerant, characterized inthat
the generator (3) is arranged to receive a heat load (Qg) from first electric components (6), the generator (3) comprising a fluid channel for receiving fluid including a mixture of the absorber and the inert, and to evaporate a part of the received fluid with the heat load (Qg) from the first electric components (6),
the evaporator (10) is arranged to receive a heat load (Qe) from second electric components (14), the evaporator (10) comprises a fluid channel including a mixture of the inert and the refrigerant for transferring heat (Qe) received from the second electric components (14) into the fluid in the fluid channel,
the absorber-condenser (20) is arranged to receive heated absorber from the generator (3) in a liquid state (A-1) and heated vaporized inert and vaporized refrigerant as a gas mixture ((R+I)-g) from the evaporator (10), to absorb the vaporized inert (I-g) by the absorber in a liquid state (A-1) in order to obtain a liquid of the miscible inert and absorber and to condense the refrigerant and to transfer heat (Qc+Qa) from the received fluids to surroundings, and
one or more of the generator (3), evaporator (10) and absorber-condenser (20) is entirely or partly manufactured of aluminum, and wherein
the inert and refrigerant are selected such that R134a is used as the inert and butane as the refrigerant fluid, or R32 is used as the inert and cyclopropane is used as the refrigerant, and
the absorber is selected to include an alkyl acetamide, a carbonate ester or a glycol ester.

2. The apparatus according to claim 1, **characterized in that** the apparatus comprises a tight enclosure (2) enclosing the generator (3) and the evaporator (3), and the absorber-condenser (20) is arranged outside of the tight enclosure for transferring heat (Qc+Qa) to the outside of the tight enclosure.

3. The apparatus according to one of claims 1 to 2, **characterized in that** the fluid channel of the evaporator (10) is arranged to receive the refrigerant in a liquid state (R-1) and the inert in a gas (I-g) state, whereby the inert in the gas state (I-g) reduces a partial pressure of the refrigerant in a liquid (R-1) state and the temperature required for evaporating the refrigerant in the liquid state, such that the refrigerant in the liquid state is evaporated.

4. The apparatus according to one of claims 1 to 3, **characterized in that** an operating temperature of the second electric components (14) is lower than an operating temperature of the first electric components (6).

5. The apparatus according to one of claims 1 to 4, **characterized in that** the first electric components (6) include high power electronic devices, and the second electric components (14) include passive electric components.

6. The apparatus according to one of claims 1 to 5, **characterized in that**
the fluid channel of the generator (3) is arranged to heat the received fluids with heat (Qg) received from the first electric components (6), to provide the absorber-condenser (20) with the absorber in a liquid state (A-1), and to provide the fluid channel of the evaporator (10) with the vaporized inert in a gas state (I-g),
the fluid channel of the evaporator (10) is arranged to receive the vaporized inert in a gas state (I-g) from the generator (3) and to receive the refrigerant in a liquid state (R-1), to heat the received fluids with heat (Qe) from the second electric components (14) and to provide the absorber-condenser (20) with the vaporized inert and vaporized refrigerant as a gas mixture ((R+I)-g), and
the absorber-condenser (20) is arranged to receive the absorber in a liquid state (A-1) from the generator and the vaporized inert and vaporized refrigerant as a gas mixture ((R+I)-g) from the evaporator (10), to absorb the vaporized inert (I-g) by the absorber in a liquid state (A-1) in order to obtain a liquid of the miscible inert and absorber and to condense the refrigerant, which is sparingly miscible or not miscible with the absorber and inert, into a liquid state (R-1) while transferring heat (Qc+Qa) from the fluids to the surroundings, and to provide the generator (3) with the absorber and inert as a liquid mixture ((A+I)-1) and the evaporator (10) with the refrigerant in a liquid state (R-1).

7. The apparatus according to one of claims 1 to 6, **characterized in that** the generator (3) is provided with a bubble pump as tubes (4) which have capillary dimensions and partly extend out of a tight enclosure (2) enclosing the generator (3) and the evaporator (3), to a higher altitude than an upper part of the absorber-condenser (20) which is located outside of the tight enclosure (2), for providing the absorber-condenser (20) with the absorber in a liquid state (A-1).

8. The apparatus according to claim 7, **characterized in that** the tubes are curved multiport extruded tubes that are divided by internal longitudinal walls into a plurality of channels, the channels of the multiport extruded tubes are provided with a manifold (7) in an upper end of the tubes (4), said manifold (7) being in a fluid connection with the evaporator (10) for providing the evaporator (10) with inert in a gas state (I-g), and with a reservoir (8) which is located lower than the manifold (7) for receiving and providing the absorber-condenser (20) with absorber in a liquid state (A-1).

9. The apparatus according to one of claims 6 to 8, **characterized in that** the apparatus comprises a solution heat exchanger (30) for cooling the absorber provided in a liquid state (A-1) from the generator to the absorber-condenser (20) with the absorber and inert as a liquid mixture ((A+I)-1) provided by the absorber-condenser (20) to the generator (3).

10. The apparatus according to one of claims 6 to 9, **characterized in that** the apparatus comprises a gas heat exchanger (40) for transferring heat between the inert provided in the gas state (I-g) from the generator (3) to the evaporator (10) and the vaporized inert and refrigerant in the gas mixture ((R+I)-g) provided by the evaporator (10) to the absorber-condenser (20).

11. A method for selecting a combination of three different working fluids including an absorber, an inert and a refrigerant for a cooling system, **characterized in that**
the inert and refrigerant are selected such that R134a is used as the inert and butane as the refrigerant fluid, or R32 is used as the inert and cyclopropane is used as the refrigerant, and
the absorber is selected to include an alkyl acetamide, a carbonate ester or a glycol ester.

## Patentansprüche

1. Vorrichtung (1), umfassend einen Generator (3), einen Verdampfer (10) und einen einen Absorber, ein inertes Mittel und ein Kühlmittel zirkulierenden Absorber-Kondensator (20), **dadurch gekennzeichnet, dass**
der Generator (3) angeordnet ist, um eine Wärmelast (Q_{g}) von ersten elektrischen Komponenten (6) zu empfangen, wobei der Generator (3) einen Fluidkanal zum Empfangen von Fluid umfasst, enthaltend eine Mischung des Absorbers und des inerten Mittels, und angeordnet ist, um einen Teil des empfangenen Fluids mit der Wärmelast (Q_{g}) von den ersten elektrischen Komponenten (6) zu verdampfen, der Verdampfer (10) angeordnet ist, um eine Wärmelast (Qₑ) von zweiten elektrischen Komponenten (14) zu empfangen, wobei der Verdampfer (10) einen Fluidkanal umfasst, enthaltend eine Mischung des inerten Mittels und des Kühlmittels, um die von den zweiten elektrischen Komponenten (14) empfangene Wärmelast (Qₑ) in das Fluid in dem Fluidkanal zu transferieren,
der Absorber-Kondensator (20) angeordnet ist, um erwärmten Absorber vom Generator (3) in einem flüssigen Zustand (A-I) und erwärmtes verdampftes inertes Mittel und verdampftes Kühlmittel als eine Gasmischung ((R+I)-g) vom Verdampfer (10) zu empfangen, um das verdampfte inerte Mittel (I-g) durch den Absorber in einem flüssigen Zustand (A-I) zu absorbieren, um eine Flüssigkeit des vermischbaren inerten Mittels und des Absorbers zu erhalten, und das Kühlmittel zu kondensieren und um die Wärme (Q_{c}+Qₐ) von den empfangenen Fluida in die Umgebung zu transferieren, und
einer oder mehrere des Generators (3), des Verdampfers (10) und des Absorber-Kondensators (20) vollständig oder teilweise aus Aluminium hergestellt sind, und wobei
das inerte Mittel und das Kühlmittel derart ausgewählt sind, dass R134a als das inerte Mittel und Butan als Kühlfluid verwendet werden, oder R32 als das inerte Mittel und Zyklopropan als das Kühlmittel verwendet werden, und
der Absorber ausgewählt ist, dass er ein Alkylacetamid, einen Karbonatester oder einen Glykolester enthält.

2. Vorrichtung nach Anspruch 1, **dadurch gekennzeichnet, dass** die Vorrichtung ein dichtes Gehäuse (2) aufweist, das den Generator (3) und den Verdampfer (3) umschließt, und der Absorber-Kondensator (20) außerhalb des dichten Gehäuses angeordnet ist, um Wärme (Q_{c}+Qₐ) vom dichten Gehäuse nach außen zu transferieren.

3. Vorrichtung nach einem der Ansprüche 1 oder 2, **dadurch gekennzeichnet, dass** der Fluidkanal des Verdampfers (10) angeordnet ist, um das Kühlmittel in einem flüssigen Zustand (R-I) und das inerte Mittel in einem gasförmigen Zustand (I-g) zu empfangen, wodurch das inerte Mittel im gasförmigen Zustand (I-g) einen Partialdruck des Kühlmittels in einem flüssigen Zustand (R-I) und die zum Verdampfen des Kühlmittels im flüssigen Zustand benötigte Temperatur derart reduziert, dass das Kühlmittel im flüssigen Zustand verdampft wird.

4. Vorrichtung nach einem der Ansprüche 1 bis 3, **dadurch gekennzeichnet, dass** eine Betriebstemperatur der zweiten elektrischen Komponenten (14) niedriger ist als eine Betriebstemperatur der ersten elektrischen Komponenten (6).

5. Vorrichtung nach einem der Ansprüche 1 bis 4, **dadurch gekennzeichnet, dass** die ersten elektrischen Komponenten (6) elektrische Hochleistungsbauteile enthalten und die zweiten elektrischen Komponenten (14) passive elektrische Komponenten enthalten.

6. Vorrichtung nach einem der Ansprüche 1 bis 5, **dadurch gekennzeichnet, dass** der Fluidkanal des Generators (3) angeordnet ist, um die empfangenen Fluida mit von den ersten elektrischen Komponenten (6) empfangener Wärme (Q_{g}) zu erwärmen, um den Absorber-Kondensator (20) mit dem Absorber in einem flüssigen Zustand (A-I) zu versorgen und um den Fluidkanal des Verdampfers (10) mit dem verdampften inerten Mittel in einem gasförmigen Zustand (I-g) zu versorgen,
der Fluidkanal des Verdampfers (10) angeordnet ist, um das verdampfte inerte Mittel in einem gasförmigen Zustand (I-g) vom Generator (3) zu empfangen und um das Kühlmittel in einem flüssigen Zustand (R-I) zu empfangen, um die empfangenen Fluida mit von den zweiten elektrischen Komponenten (14) empfangener Wärme (Qₑ) zu erwärmen und um den Absorber-Kondensator (20) mit dem verdampften inerten Mittel und verdampften Kühlmittel als eine Gasmischung ((R+I)-g) zu versorgen, und
der Absorber-Kondensator (20) angeordnet ist, um den Absorber in einem flüssigen Zustand (A-I) vom Generator und das verdampfte inerte Mittel und verdampfte Kühlmittel als eine Gasmischung ((R+I)-g) vom Verdampfer (10) zu empfangen, um das verdampfte inerte Mittel (I-g) durch den Absorber in einem flüssigen Zustand (A-I) zu absorbieren, um eine Flüssigkeit aus dem vermischbaren inerten Mittel und dem Absorber zu erhalten und um das Kühlmittel, das mit dem Absorber und dem inerten Mittel kaum vermischbar oder nicht vermischbar ist, in einen flüssigen Zustand (R-I) zu kondensieren, während es Wärme (Q_{c}+Qₐ) von den Fluida an die Umgebung transferiert, und um den Generator (3) mit dem Absorber und inerten Mittel als eine flüssige Mischung ((A+I)-I) und den Verdampfer (10) mit dem Kühlmittel in einem flüssigen Zustand (R-I) zu versorgen.

7. Vorrichtung nach einem der Ansprüche 1 bis 6, **dadurch gekennzeichnet, dass** der Generator (3) mit einer Blasenpumpe als Röhren (4) versehen ist, die Kapillarmaße aufweisen und sich teilweise aus einem den Generator (3) und den Verdampfer (3) umschließenden dichten Gehäuse (2) nach außen in einer größeren Höhe erstrecken als ein oberer Teil des Absorber-Kondensators (20), der außerhalb des dichten Gehäuses (2) angeordnet ist, um den Absorber-Kondensator (20) mit dem Absorber in einem flüssigen Zustand (A-I) zu versorgen.

8. Vorrichtung nach Anspruch 7, **dadurch gekennzeichnet, dass** die Röhren gekrümmte extrudierte Multiport-Röhren sind, die durch interne Längswände in eine Vielzahl von Kanälen aufgeteilt sind, wobei die Kanäle der extrudierten Multiport-Röhren mit einem Sammelrohr (7) an oberen Enden der Röhren (4) versehen sind, wobei das Sammelrohr (7) in einer strömungstechnischen Verbindung mit dem Verdampfer (10) ist, um den Verdampfer (10) mit inertem Mittel in einem gasförmigen Zustand (I-g) zu versorgen, und mit einem Reservoir (8), das weiter unten als das Sammelrohr (7) angeordnet ist, um den Absorber in flüssigem Zustand (A-I) zu empfangen und den Absorber-Kondensator (20) damit zu versorgen.

9. Vorrichtung nach einem der Ansprüche 6 bis 8, **dadurch gekennzeichnet, dass** die Vorrichtung einen Lösungswärmetauscher (30) zum Kühlen des in einem flüssigem Zustand (A-I) vom Generator an den Absorber-Kondensator (20) bereitgestellten Absorbers mit dem Absorber und inerten Mittel als für den Generator (3) vom Absorber-Kondensator (20) bereitgestellte flüssige Mischung ((A+I)-I) umfasst.

10. Vorrichtung nach einem der Ansprüche 6 bis 9, **dadurch gekennzeichnet, dass** die Vorrichtung einen Gaswärmertauscher (40) zum Transferieren von Wärme zwischen dem vom Generator (3) zum Verdampfer (10) bereitgestellten inerten Mittel im gasförmigen Zustand (I-g) und dem vom Verdampfer (10) zum Absorber-Kondensator (20) bereitgestellten verdampften inerten Mittel und dem Kühlmittel in der Gasmischung ((R+I)-g) umfasst.

11. Verfahren zum Auswählen einer Kombination aus drei Arbeitsflüssigkeiten, enthaltend einen Absorber, ein inertes Mittel und ein Kühlmittel für ein Kühlsystem, **dadurch gekennzeichnet, dass**
das inerte Mittel und das Kühlmittel derart ausgewählt sind, dass R134a als das inerte Mittel verwendet wird und Butan als das Kühlfluid, oder R32 als das inerte Mittel verwendet wird und Zyklopropan als das Kühlmittel verwendet wird,
der Absorber ausgewählt ist, dass er ein Alkylacetamid, einen Karbonatester oder einen Glykolester enthält.

## Revendications

1. Appareil (1) comprenant un générateur (3), un évaporateur (10) et un absorbeur-condenseur (20) faisant circuler un absorbeur, une matière inerte et un réfrigérant, **caractérisé en ce que**
le générateur (3) est agencé pour recevoir une charge de chaleur (Qg) provenant de premiers composants électriques (6), le générateur (3) comprenant un canal de fluide pour recevoir du fluide incluant un mélange de l'absorbeur et de la matière inerte et pour évaporer une partie du fluide reçu avec la charge de chaleur (Qg) provenant des premiers composants électriques (6),
l'évaporateur (10) est agencé pour recevoir une charge de chaleur (Qe) provenant de seconds composants électriques (14), l'évaporateur (10) comprend un canal de fluide incluant un mélange de la matière inerte et du réfrigérant pour transférer la chaleur (Qe) reçue en provenance des seconds composants électriques (14) dans le fluide dans le canal de fluide,
l'absorbeur-condenseur (20) est agencé pour recevoir l'absorbeur chauffé en provenance du générateur (3) dans un état liquide (A-I) et la matière inerte chauffée vaporisée et le réfrigérant vaporisé en tant que mélange de gaz ((R+I)-g) en provenance de l'évaporateur (10), pour absorber la matière inerte vaporisée (I-g) par l'absorbeur dans un état liquide (A-I) afin d'obtenir un liquide de la matière inerte miscible et de l'absorbeur et pour condenser le réfrigérant et transférer la chaleur (Qc+Qa) provenant des fluides reçus à l'environnement, et
un ou plus du générateur (3), de l'évaporateur (10) et de l'absorbeur-condenseur (20) sont entièrement ou partiellement fabriqués en aluminium, et dans lequel
la matière inerte et le réfrigérant sont sélectionnés de sorte que du R134a est utilisé en tant que matière inerte et du butane en tant que fluide réfrigérant, ou du R32 est utilisé en tant que matière inerte et du cyclopropane est utilisé en tant que réfrigérant, et
l'absorbeur est sélectionné pour inclure un acétamide d'alkyle, un ester de carbonate ou un ester de glycol.

2. Appareil selon la revendication 1, **caractérisé en ce que** l'appareil comprend une enceinte étroite (2) enfermant le générateur (3) et l'évaporateur (3), et l'absorbeur-condenseur (20) est agencé à l'extérieur de l'enceinte étroite pour transférer la chaleur (Qc+Qa) à l'extérieur de l'enceinte étroite.

3. Appareil selon l'une des revendications 1 à 2, **caractérisé en ce que** le canal de fluide de l'évaporateur (10) est agencé pour recevoir le réfrigérant dans un état liquide (R-I) et la matière inerte dans un état de gaz (I-g), de sorte que la matière inerte dans l'état de gaz (I-g) réduit une pression partielle du réfrigérant dans un état liquide (R-I) et la température requise pour évaporer le réfrigérant dans l'état liquide, de sorte que le réfrigérant dans l'état liquide est évaporé.

4. Appareil selon l'une des revendications 1 à 3, **caractérisé en ce qu'**une température de fonctionnement des seconds composants électriques (14) est inférieure à une température de fonctionnement des premiers composants électriques (6).

5. Appareil selon l'une des revendications 1 à 4, **caractérisé en ce que** les premiers composants électriques (6) incluent des dispositifs électroniques de forte puissance et les seconds composants électriques (14) incluent des composants électriques passifs.

6. Appareil selon l'une des revendications 1 à 5, **caractérisé en ce que**
le canal de fluide du générateur (3) est agencé pour chauffer les fluides reçus avec la chaleur (Qg) reçue en provenance des premiers composants électriques (6), pour fournir à l'absorbeur-condenseur (20) l'absorbeur dans un état liquide (A-I) et pour fournir au canal de fluide de l'évaporateur (10) la matière inerte vaporisée dans un état de gaz (I-g),
le canal de fluide de l'évaporateur (10) est agencé pour recevoir la matière inerte vaporisée dans un état de gaz (I-g) en provenance du générateur (3) et pour recevoir le réfrigérant dans un état liquide (R-I), pour chauffer les fluides reçus avec la chaleur (Qe) provenant des seconds composants électriques (14) et pour fournir à l'absorbeur-condenseur (20) la matière inerte vaporisée et le réfrigérant vaporisé en tant que mélange de gaz ((R+I)-g), et
l'absorbeur-condenseur (20) est agencé pour recevoir l'absorbeur dans un état liquide (A-I) en provenance du générateur et la matière inerte vaporisée et le réfrigérant vaporisé en tant que mélange de gaz ((R+I)-g) en provenance de l'évaporateur (10), pour absorber la matière inerte vaporisée (I-g) par l'absorbeur dans un état liquide (A-I) afin d'obtenir un liquide de la matière inerte miscible et de l'absorbeur et pour condenser le réfrigérant, qui est miscible avec modération ou non miscible avec l'absorbeur et la matière inerte, dans un état liquide (R-I) tout en transférant la chaleur (Qc+Qa) provenant des fluides à l'environnement, et pour fournir au générateur (3) l'absorbeur et la matière inerte en tant que mélange liquide ((A+I)-I) et à l'évaporateur (10) le réfrigérant dans un état liquide (R-I).

7. Appareil selon l'une des revendications 1 à 6, **caractérisé en ce que** le générateur (3) est muni d'une pompe à bulles comme des tubes (4) qui ont des dimensions capillaires et s'étendent en partie hors d'une enceinte étroite (2) enfermant le générateur (3) et l'évaporateur (3), à une altitude plus élevée qu'une partie supérieure de l'absorbeur-condenseur (20) qui est situé à l'extérieur de l'enceinte étroite (2), pour fournir à l'absorbeur-condenseur (20) l'absorbeur dans un état liquide (A-I).

8. Appareil selon la revendication 7, **caractérisé en ce que** les tubes sont des tubes extrudés incurvés à plusieurs orifices qui sont divisés par des parois longitudinales internes en une pluralité de canaux, les canaux des tubes extrudés à plusieurs orifices sont munis d'un collecteur (7) dans une extrémité supérieure des tubes (4), ledit collecteur (7) étant en communication à fluide avec l'évaporateur (10) pour fournir à l'évaporateur (10) de la matière inerte dans un état de gaz (I-g), et d'un réservoir (8) qui est situé plus bas que le collecteur (7) pour recevoir et fournir à l'absorbeur-condenseur (20) l'absorbeur dans un état liquide (A-I).

9. Appareil selon l'une des revendications 6 à 8, **caractérisé en ce que** l'appareil comprend un échangeur thermique de solution (30) pour refroidir l'absorbeur fourni dans un état liquide (A-I) en provenance du générateur à destination de l'absorbeur-condenseur (20) avec l'absorbeur et la matière inerte en tant que mélange liquide ((A+I)-I) fourni par l'absorbeur-condenseur (20) au générateur (3).

10. Appareil selon l'une des revendications 6 à 9, **caractérisé en ce que** l'appareil comprend un échangeur thermique de gaz (40) pour transférer la chaleur entre la matière inerte fournie dans l'état de gaz (I-g) en provenance du générateur (3) à destination de l'évaporateur (10) et la matière inerte vaporisée et le réfrigérant dans le mélange de gaz ((R+I)-g) fourni par l'évaporateur (10) à l'absorbeur-condenseur (20).

11. Procédé pour sélectionner une combinaison de trois fluides de travail différents incluant un absorbeur, une matière inerte et un réfrigérant pour un circuit de refroidissement, **caractérisé en ce que**
la matière inerte et le réfrigérant sont sélectionnés de sorte que du R134a est utilisé en tant que matière inerte et du butane en tant que fluide réfrigérant, ou du R32 est utilisé en tant que matière inerte et du cyclopropane est utilisé en tant que réfrigérant, et
l'absorbeur est sélectionné pour inclure un acétamide d'alkyle, un ester de carbonate ou un ester de glycol.
